# FASCICULE DE BREVET EUROPEEN

(11) **EP 2 320 572 B1**
(45) Date de publication et mention de la délivrance du brevet: **03.12.2014**
(21) Numéro de dépôt: 10354067.0
(22) Date de dépôt: 26.10.2010
(51) Int. Cl.: H03M 1/38, H03M 1/14

(54) **Convertisseur analogique-numérique, sur deux bits, à approximations successives**
Zwei-Bit-Analog-Digital-Wandler nach dem Verfahren der schrittweise Annäherung
Two bit successive approximation type analogue-to-digital converter

(30) Priorité: 03.11.2009 FR 0905267
(43) Date de publication de la demande: 11.05.2011
(73) Titulaire: Société Française de Détecteurs Infrarouges - SOFRADIR, 92290 Châtenay Malabry (FR)
(72) Inventeur: Decaens, Gilbert, 38000 Grenoble (FR)
(74) Mandataire: Talbot, Alexandre

(56) Documents cités:
- SATOMI OGAWA ET AL: "A HIGH SPEED, SWITCHED-CAPACITOR ANALOG-TO-DIGITAL CONVERTER USING UNITY-GAIN BUFFERS", IEICE TRANSACTIONS ON FUNDAMENTALS OF ELECTRONICS,COMMUNICATIONS AND COMPUTER SCIENCES, ENGINEERING SCIENCES SOCIETY, TOKYO, JP, vol. 76A, no. 6, 1 juin 1993 (1993-06-01), pages 924-930, XP000390389, ISSN: 0916-8508

## Description

### Domaine technique de l'invention

L'invention est relative à un convertisseur analogique-numérique à approximations successives.

### État de la technique

La conversion d'un signal analogique en un signal numérique est réalisée de manière conventionnelle au moyen de convertisseurs analogique-numérique. Plusieurs types de convertisseurs analogique-numérique sont connus et leurs utilisations sont définies en fonction de leur temps de conversion, de leur précision et en fonction de leur coût de fabrication qui tient compte des difficultés de réalisation et/ou de la surface utilisée sur une puce et/ou de la consommation. Les convertisseurs se répartissent en différentes catégories, les plus connus sont les convertisseurs flash, les convertisseurs « pipeline », les convertisseurs à approximations successives, les convertisseurs « rampe » et les convertisseurs « Sigma-Delta ».

Les convertisseurs à approximations successives sont des systèmes bouclés qui sont construits autour d'un seul étage constitué par un convertisseur à un bit. La conversion de la tension à convertir Vin est réalisée bit par bit à chaque nouvelle itération, c'est-à-dire au moyen de cycles d'horloges successifs, en partant du bit de poids le plus fort (« Most Significant Bit » en anglais ») jusqu'au bit de poids le plus faible (« Lowest Significant Bit »). Ainsi, pour convertir une tension Vin sur n bits, il faut au minimum n itérations. Il apparaît alors de manière évidente que plus la résolution numérique recherchée est importante, plus le nombre de bits de conversion nécessaires est élevé et plus le temps de conversion est important.

Le fonctionnement d'un tel convertisseur cyclique peut être expliqué de la manière suivante. La tension à convertir Vin est comprise dans une gamme de tensions prédéfinies, délimitée par des première et seconde tensions. Cette gamme de tensions est divisée en deux sous-gammes égales, une première sous-gamme comportant les tensions les plus basses et la deuxième sous-gamme comportant les tensions les plus hautes. La délimitation de ces sous-gammes est réalisée au moyen d'une tension de référence Vref. On cherche ensuite à connaître dans quelle sous-gamme se situe la tension Vin. Selon que la tension à convertir se situe dans la sous-gamme des valeurs basses ou des valeurs hautes de la gamme de départ, on affecte respectivement un « 0 » ou un « 1 » au bit le plus élevé représentatif de la comparaison à la tension de référence Vref. La sous-gamme comportant la tension Vin est alors de nouveau divisée en deux parties égales et on recherche de nouveau à quelle partie appartient la tension à convertir et un second bit égal à 1 ou à 0 est défini à partir de cette nouvelle comparaison et ainsi de suite selon la résolution recherchée.

Deux approches sont envisageables pour réaliser cette conversion. Dans une première approche, selon que le bit calculé est égal à 1 ou 0, la tension de référence peut être soustraite à une tension représentative de la tension à convertir. L'une de la première ou de la seconde tension est remplacée par la tension de référence Vref de manière à représenter lors de l'itération suivante la nouvelle gamme accessible c'est-à-dire la sous-gamme de l'itération précédente qui comprenait la tension à convertir.

Dans une seconde approche, qui est équivalente du point de vue du résultat de la conversion, les tensions définissant les gammes accessibles sont fixes et c'est la tension à convertir Vin (qui est multipliée par deux), à laquelle on a soustrait ou non la tension de référence pour définir la tension intermédiaire.

Selon que la tension à convertir se situe dans l'une ou l'autre des sous-gammes, une tension intermédiaire Vi représentative de la tension à convertir est calculée à partir de la tension à convertir et de la tension de référence. Cette tension intermédiaire Vi est la tension à convertir de l'itération suivante ou du bloc suivant, c'est-à-dire la tension utilisée pour la détermination du bit suivant.

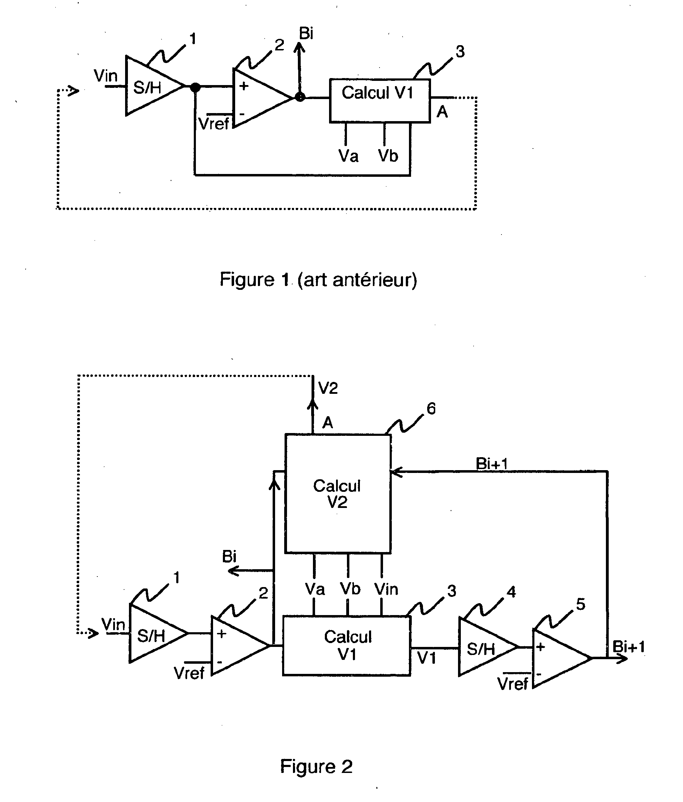

Un exemple typique de convertisseur à approximations successives est un convertisseur de type cyclique ou algorithmique illustré à la figure 1.

Dans un convertisseur cyclique, la tension à convertir Vin est comparée successivement à une fraction binaire d'une tension de référence Vref qui est de plus en plus précise au fur et à mesure des coups d'horloge successifs. La tension à convertir Vin et l'ensemble des tensions intermédiaires Vi sont comparées à la référence de comparaison la tension Vref.

La tension à convertir Vin est appliquée à une entrée d'un premier échantillonneur/bloqueur 1 (« Sample And Hold » en anglais). La borne de sortie du premier échantillonneur-bloqueur 1 est connectée à une première entrée d'un premier comparateur 2 à sortie numérique sur un bit. La tension de référence Vref est appliquée sur la seconde entrée du comparateur 2 à sortie numérique. La borne de sortie du comparateur 2 délivre alors un bit *Bi* représentatif de la comparaison entre les tensions appliquées à ses deux bornes d'entrée. La borne de sortie du comparateur 2 est connectée à un registre qui sauvegarde le bit *Bi* délivré. La borne de sortie du comparateur est également connectée à une borne d'entrée d'un moyen 3 de calcul d'une première tension intermédiaire V1, tel qu'un calculateur d'une première tension intermédiaire V1. La première tension intermédiaire V1 est représentative de la tension 2Vin-(Va+Vb)/2+*Bi*.(Va-Vb)/2+B̅*i*.(Vb-Va)/2selon l'approche utilisée pour la gestion des tensions lors des itérations comme expliqué précédemment. Selon la valeur du bit *Bi,* le calculateur 3 délivre en sortie une tension V1 représentative de 2Vin-Vb ou 2Vin-Va qui correspond au résidu de type analogique qui est appliqué à l'entrée du prochain étage de convertisseur utilisé pour convertir la tension Vin sur un deuxième bit. La borne de sortie du calculateur 3 peut alors être connectée à l'entrée de ce même étage (figure 1) ou alors à l'entrée de l'étage suivant (typiquement dans une architecture pipeline non représentée). Ainsi, au moyen de cette architecture, la tension à convertir Vin est appliquée à l'entrée du premier échantillonneur-bloqueur 1 qui la stocke en mémoire pendant toute l'itération. En sortie du premier échantillonneur-bloqueur 1, la tension Vin est comparée à la tension de référence Vref par le premier comparateur numérique 2 qui délivre en sortie un bit *Bi* représentatif de la comparaison. Par convention, si la tension Vin est supérieure à la tension Vref, le premier comparateur 2 renvoie un « 1 », dans le cas contraire, il renvoie un « 0 ». Ce bit *Bi* représentatif est enregistré dans un registre (non représenté), et est également appliqué au calculateur 3 de la première tension intermédiaire V1. Ainsi, à chaque itération, le même convertisseur détermine un bit représentatif de la tension à convertir Vin bien que cette tension ne soit pas réellement appliquée au convertisseur pendant toute la durée de la conversion. En effet, lors de la seconde itération et des itérations suivantes, la conversion est réalisée sur la première tension intermédiaire V1 qui est représentative de la tension à convertir et des tensions intermédiaires suivantes représentatives des tensions intermédiaires précédentes.

Un exemple de réalisation est décrit dans la publication de Ogawa et al. « A High Speed Switched-Capacitor Analog-to-Digital Converter Using Unity-Gain Buffers » IEICE transactions on Fundamentals of Electronics, Communications and Computer Sciences, Engineering Sciences Society Vol/ 76A, nº6, 1993, pp924-930. Dans ce mode de réalisation, deux comparateurs sont mis en série et sont agencés de manière à utiliser les deux phases d'un coup d'horloge pour générer successivement les deux bits à partir de la tension à convertir et de la tension intermédiaire.

D'une manière générale, les convertisseurs à approximations successives sont limités à une résolution sur 10 bits car les imprécisions sur les différentes tensions dégradent la précision du résultat numérique final et une conversion sur plus de 10 bits n'apporte pas plus de précision qu'une conversion sur 16 bits à cause des erreurs successives introduites à chaque itération.

### Objet de l'invention

L'invention a pour objet la réalisation d'un convertisseur qui assure une plus grande précision dans la conversion numérique sur n bits d'une tension analogique, des temps de conversion inférieurs ou égaux à ceux correspondant à un convertisseur cyclique sur n bits tout en conservant une consommation et une surface de convertisseur réduites pour être utilisé dans des systèmes embarqués.

Le convertisseur selon l'invention est obtenu au moyen des revendications annexées et plus particulièrement par le fait que ladite première tension intermédiaire étant comprise dans une seconde gamme de tensions représentatives de la sous-gamme dans laquelle est comprise la tension à convertir, ledit premier étage comporte :
- un second moyen de comparaison de la première tension intermédiaire à au moins une seconde tension représentative de la division de ladite seconde gamme en au moins deux sous-gammes égales, ledit second moyen de comparaison numérique délivrant, sur une seconde sortie numérique, une seconde valeur numérique sur au moins un second bit représentatif de ladite comparaison,
- un second moyen de calcul d'une tension résiduelle délivrant sur une sortie analogique du premier étage ladite tension résiduelle fonction de la tension à convertir, des première et seconde valeurs numériques et desdites première et seconde tensions,
la tension résiduelle étant appliquée à l'entrée du premier étage ou à une entrée d'un étage ultérieur de même type que le premier étage.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, un convertisseur cyclique à un bit, selon l'art antérieur,
- la figure 2 représente, de manière schématique, un convertisseur à approximations successives à deux bit, selon l'invention,
- la figure 3 représente, un mode de réalisation particulier correspondant au convertisseur illustré à la figure 2,
- la figure 4 représente, de manière schématique, une variante de réalisation d'un convertisseur à approximations successives à deux bits, selon l'invention,
- la figure 5 représente, de manière schématique, une variante de réalisation d'un convertisseur à approximations successives, selon l'invention.

### Description d'un mode de réalisation préférentiel de l'invention

Comme illustré à la figure 2, dans un premier mode de réalisation particulier, le convertisseur analogique-numérique à approximations successives sur au moins deux bits est composé d'au moins un premier étage comportant un convertisseur analogique-numérique sur deux bits *Bi* et *B*_{*i*+1}*.* Ce premier étage comporte une borne d'entrée sur laquelle la tension à convertir Vin est appliquée. Le premier étage comporte également deux bornes de sortie numérique associées aux bits *Bi* et *B*_{*i*+1} et une borne de sortie analogique A qui peut être associée avec un autre étage ou rebouclée sur l'entrée de ce premier étage. D'une manière générale, le convertisseur est composé d'au moins un premier étage que ce soit pour une intégration dans une architecture de type pipeline ou cyclique.

Dans une architecture de type pipeline, la borne de sortie analogique A de l'étage représenté à la figure 2 est connectée à une entrée d'un convertisseur de même type formant l'étage suivant. De cette manière, le premier étage convertit les deux premiers bits de la tension à convertir Vin et fournit à l'étage suivant un résidu analogique, c'est-à-dire une tension résiduelle V2, qui est convertie pour former les deux bits suivants. Il y a alors, dans cet exemple, une conversion de la tension Vin sur au moins quatre bits.

Dans une architecture dite cyclique, il n'y a qu'un seul étage de convertisseur analogique-numérique, le premier étage. La borne de sortie analogique A est alors reconnectée à la borne d'entrée du premier et unique étage. De cette manière, à chaque itération, le convertisseur convertit deux bits de la tension à convertir Vin. A la première itération, le convertisseur délivre les premier et second bits à partir de la tension à convertir Vin et à l'itération suivante, le convertisseur délivre les troisième et quatrième bits à partir du résidu analogique, la tension V2, délivré lors du second cycle d'horloge ou de l'itération suivante. La reconnexion entre la borne de sortie analogique A et la borne d'entrée est réalisée de manière conventionnelle.

D'une manière générale, on peut obtenir un convertisseur analogique-numérique sur 2n bits en additionnant n étages successifs de convertisseurs sur deux bits (architecture de type pipeline) ou en réalisant au moins n boucles de conversion sur deux bits sur le premier étage (convertisseur cyclique).

De manière conventionnelle, la tension à convertir Vin est comprise entre des première Va et seconde Vb tensions qui représentent les limites de la gamme accessible à la tension Vin. La seconde tension Vb est supérieure à la première tension Va. Selon les différents modes de réalisation possibles, la gamme accessible est divisée en au moins deux portions qui sont délimitées par au moins une première tension de référence. Si la gamme accessible comporte un nombre pair de sous-gammes, la gamme est divisée en des sous-gammes égales. Si la gamme accessible comporte un nombre impair de sous-gammes, l'étendue des différentes sous-gammes peut être variable. Avantageusement, la gamme accessible est divisée en deux ou trois sous-gammes. Dans le cas particulier où la gamme est divisée en deux portions égales, la délimitation est réalisée par une seule tension de référence Vref qui est égale (Va+Vb)/2.

A titre d'exemple, si les première et seconde tensions sont égales en valeur absolues, mais opposées en signes (Va = -Vb), alors la tension de référence est nulle (Vref = 0). Si les première et seconde tensions sont respectivement égales à 0 et V (Va = 0, Vb = V), alors la tension de référence Vref est égale à V/2. La tension de référence est alors disposée à équipotentielle des tensions Va et Vb.

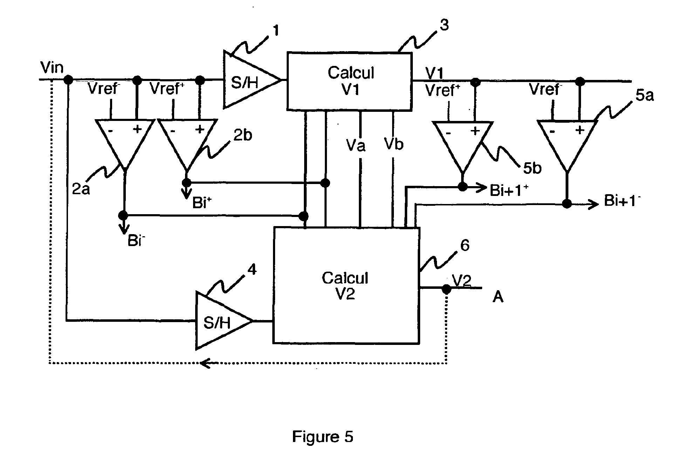

Il est également possible de diviser la gamme en plus de deux portions, typiquement trois portions, afin d'éviter les erreurs des moyens de comparaison. Dans ce mode de réalisation, illustré à la figure 5 la tension à convertir Vin est comparée à plusieurs tensions de référence, par exemple des première et seconde tensions de référence Vref⁻ et Vref⁺. Un exemple de mise en oeuvre de ce procédé de comparaison est décrit par exemple par Ginetti et al « A CMOS 13-b Cyclic RSD A/D Converter » IEEE Journal of Solid-State Circuits Vol.27, N°7, July 1992.

De manière classique, le convertisseur peut faire évoluer la tension à convertir Vin entre deux itérations ou alors il peut faire évoluer les tensions délimitant la gamme accessible et la tension de référence Vref. De ce fait dans un mode de réalisation, la tension à convertir Vin est multipliée, par exemple, par un facteur deux ou par un facteur quatre alors que dans un autre mode de réalisation, la gamme accessible est divisée par deux ou par quatre en modifiant les tensions limites.

Comme précisé précédemment, selon le mode de réalisation utilisé, les première et seconde tensions Va et Vb peuvent être identiques entre les différents étages et au sein d'un étage, mais ces tensions peuvent également évoluer entre les différents étages et au sein des étages afin de représenter les gammes de tensions accessibles à la tension à convertir ou à sa tension représentative qui va être convertie.

Comme illustré aux figures 2, 3 et 4, le premier étage du convertisseur comporte de manière générale, un premier moyen 2 de comparaison à sortie numérique, par exemple un premier comparateur à sortie numérique, de la tension à convertir Vin à au moins la première tension de référence représentative de la division de la gamme de tensions accessible en au moins deux sous-gammes. Ce premier comparateur 2 à sortie numérique délivre, sur la première borne de sortie numérique du premier étage, une première valeur numérique, sur au moins un premier bit *Bi,* qui est représentative de la comparaison entre la tension à convertir Vin et la ou les tensions de référence. A titre d'exemple, si la gamme est divisée en deux sous-gammes, le premier comparateur 2 délivre un premier bit et si la gamme est divisée en trois sous-gammes, le premier moyen de comparaison délivre deux bits.

Le premier étage comporte également un moyen 3 de calcul, tel qu'un premier calculateur, délivrant une première tension intermédiaire V1. Cette première tension intermédiaire V1 est fonction de la tension à convertir Vin, de la valeur du premier résultat numérique (au moins le premier bit *Bi)* et des première Va et seconde Vb tensions. De cette manière, le moyen 3 de calcul est connecté directement à la tension Vin et délivre en sortie la tension intermédiaire V1 provenant de la tension Vin des première et seconde tensions Va et Vb et de la valeur du premier bit *Bi.* Le moyen 3 de calcul est un moyen de calcul direct car la tension délivrée en sortie provient directement de la valeur de la tension à convertir Vin, c'est-à-dire sans altération. L'échantillonneur bloqueur permet de réaliser l'échantillonnage de la tension Vin et donc de délivrer une tension constante à l'entrée du moyen de calcul.

Par convention, la tension à convertir Vin est située dans une première gamme de tensions qui est délimitée par les première et seconde tensions et la première tension intermédiaire V1 est située dans une seconde gamme de tensions. Cette seconde gamme de tensions est représentative de la sous-gamme de la première gamme de tension qui comportait la tension à convertir Vin. Ainsi chaque tension intermédiaire est située dans une gamme dédiée.

Un second moyen 5 de comparaison avec une sortie numérique sur un bit est également intégré dans le premier étage. Ce second moyen 5 de comparaison numérique, tel qu'un second comparateur à sortie numérique, compare la première tension intermédiaire V1 à au moins une seconde tension représentative de la division de la seconde gamme en au moins deux sous-gammes. Comme pour la première gamme, la seconde gamme peut être divisée par un nombre pair ou impair de sous-gammes. La seconde gamme peut être divisée par un nombre pair de sous-gammes égales ou alors par un nombre impair de sous-gammes ayant une étendue variable. Dans le cas d'une gamme divisée en deux sous-gammes délimitée par la tension de référence, le second moyen 5 de comparaison numérique compare la première tension intermédiaire V1 à la tension de référence.

Le second comparateur 5 à sortie numérique délivre en sortie une seconde sortie numérique, au moins un second bit *B*_{*i*+1} sur la seconde borne de sortie numérique du premier étage. Cette seconde sortie numérique est représentative de la comparaison entre la première tension intermédiaire V1 et la ou les tensions de référence.

Dans le cas d'une division de chaque gamme en deux sous-gammes, la tension de référence Vref qui est comparée à la tension intermédiaire peut être identique, ou différente, en valeur à la tension qui a été utilisée comme référence pour la comparaison de la tension à convertir Vin. La valeur de la tension de référence entre ces deux étapes de comparaison dépend du mode de gestion des tensions entre les différentes sous-gammes comme cela a été expliqué précédemment. Il en va de même des multiples tensions de références utilisées par chaque comparateur lorsque la gamme est divisée en plus de deux sous-gammes.

Un second moyen 6 de calcul, tel qu'un second calculateur, d'une tension résiduelle délivre la tension résiduelle V2 sur la sortie analogique du premier étage. La tension résiduelle V2 est fonction de la tension à convertir Vin, des valeurs des premier et second résultats numériques et des première et seconde tensions Va et Vb. Le second moyen 6 de calcul est également un moyen de calcul direct car la valeur de la tension résiduelle provient directement de la tension à convertir Vin, des valeurs de première et seconde tensions Va et Vb et des valeurs des premier et second bits. La tension résiduelle V2 est obtenue directement à partir de la tension Vin et non à partir de la tension intermédiaire V1. Bien que la tension intermédiaire provienne de la tension Vin, la tension Vin est modifiée et donc détériorée pour obtenir la tension intermédiaire. La tension résiduelle V2 obtenue à partir du second moyen 6 de calcul est donc moins sensible aux erreurs de conversions. La tension à convertir Vin est appliquée directement à l'entrée du second moyen 6 de calcul et de ce fait, la sortie analogique du second moyen de calcul est réappliquée sur son entrée ou sur l'entrée de l'étage suivant. Dans le cas d'une architecture cyclique, la sortie analogique du second moyen 6 de calcul est appliquée à l'entrée du même second moyen 6 de calcul.

Dans les modes de réalisation illustrés aux figures 2 à 5, la tension à convertir Vin est appliquée directement à l'entrée des moyens de calcul 3 et 6, par l'intermédiaire ou non d'un échantillonneur bloqueur. L'entrée analogique de l'étage alimente les deux moyens de calcul avec la même tension à convertir. Cela permet d'appliquer la même tension à l'entrée des différents moyens de calcul et donc de limiter les erreurs successives de conversion. La sortie analogique du premier moyen 3 de calcul n'est pas utilisée pour calculer une autre tension. Cette sortie n'est utilisée que par le second moyen de comparaison 5 pour fournir le second bit.

Dans des modes de réalisations particuliers qui vont être décrits par la suite, le premier étage peut comporter des éléments supplémentaires afin de permettre un transfert des différentes données, de manière organisée, dans le temps. Pour ce faire, le premier étage va comporter, par exemple, des blocs échantillonneur/bloqueur.

Dans le premier mode de réalisation illustré à la figure 2, le premier étage du convertisseur analogique-numérique comporte un premier échantillonneur-bloqueur 1 connecté à la borne d'entrée du premier étage. La tension à convertir Vin est donc appliquée à l'entrée du premier échantillonneur-bloqueur 1. Le premier échantillonneur-bloqueur 1 comporte une entrée de commande, non représentée, qui permet de définir à quel instant la tension imposée à l'entrée du premier échantillonneur-bloqueur 1 doit être échantillonnée. Après échantillonnage, la tension mesurée est ensuite délivrée sur la borne de sortie du premier échantillonneur-bloqueur 1 jusqu'à ce qu'un nouveau signal de commande soit appliqué à la borne de commande. De manière avantageuse, la tension mesurée est délivrée pendant tout le temps de la première phase de l'itération. La tension délivrée par la sortie du premier échantillonneur-bloqueur 1 est égale à la tension à convertir Vin ou très proche, l'échantilonneur-bloqueur n'étant pas parfait. La qualité du résultat final du convertisseur dépend, de manière non négligeable, de la qualité des échantillonneurs-bloqueurs utilisés. Afin de conserver une qualité de conversion élevée cette architecture utilise un faible nombre d'échantillonneurs-bloqueurs comparé au résultat numérique obtenu avec des convertisseurs sur un bit de l'état de l'art.

La borne de sortie du premier échantillonneur-bloqueur 1 est connectée à une première borne d'entrée du premier moyen de comparaison 2 à sortie numérique sur un bit qui est ici constitué par un premier comparateur ayant une sortie numérique sur un bit.

La tension de référence Vref est appliquée à la deuxième borne d'entrée du premier comparateur 2 qui compare alors la tension de référence Vref à la tension à convertir Vin. Selon le résultat de la comparaison entre les tensions à ses bornes, le premier comparateur 2 délivre un premier résultat numérique, par exemple, un premier bit *Bi* qui peut être égale à 1 ou à 0.Par convention, si la gamme est divisée en deux sous-gammes, le bit vaut 1 si la tension est supérieure à la tension de référence et il vaut 0 dans les autres cas. Le premier bit *Bi* est égal à 0 ou à 1 par convention, mais en réalité la valeur 1 représente la valeur de l'alimentation du comparateur. Ce premier bit *Bi* correspond au bit de poids le plus fort de la conversion numérique. Ce premier bit est délivré vers l'extérieur par la première borne de sortie numérique du premier étage.

La borne de sortie du premier comparateur 2 à sortie numérique est connectée à un registre (non représenté) qui emmagasine le résultat numérique, typiquement du bit *Bi* (le bit ne pouvant être égale qu'à « 0 » ou à « 1 »). La borne de sortie du premier comparateur 2 est également connectée à l'entrée du calculateur 3 de la première tension intermédiaire V1.

Le calculateur 3 de la première tension intermédiaire V1 comporte donc une borne d'entrée numérique sur laquelle est appliqué le premier bit *Bi.* Il comporte également des bornes sur lesquelles sont appliquées des tensions représentatives respectivement de la tension à convertir Vin, de la première tension Va et de la seconde tension Vb. Le calculateur 3 de la première tension intermédiaire V1 comporte également une borne de sortie analogique qui délivre la première tension intermédiaire V1.

La première tension intermédiaire V1 est donc fonction de la tension à convertir Vin, des première Va et seconde Vb tensions et de la valeur du premier bit *Bi.* La première tension intermédiaire V1 est égale ou représentative de la tension 2Vin-(Va+Vb)/2+*Bi*.(Va-Vb)/2+*B̅i*.(Vb-Va)/2 dans laquelle *B̅i* est égale à 1-*Bi*. La première tension intermédiaire peut également être écrite sous la forme suivante V1 = 2Vin - *Bi.VB*-*B̅i*.Va ou une tension représentative de cette formule.

Selon le mode de gestion des tensions choisi pour le convertisseur, la tension V1 peut être égale, par exemple, à Vin-(Va+Vb)/4+*Bi*.(Va-Vb)/4+*B̅i*.(Vb-Va)/4. Cependant, ce mode de gestion est moins utilisé car il est plus difficile à mettre en oeuvre. Seul le mode de gestion précédent est donc utilisé dans le reste de la description pour un souci de clarté. Dans ce mode de réalisation, la tension à convertir Vin et les tensions intermédiaires sont toutes comprises dans la même gamme de tension.

La première tension intermédiaire V1 est appliquée à l'entrée d'un second échantillonneur-bloqueur 4 qui est réalisé, de préférence, de manière analogue au premier échantillonneur-bloqueur 1. La tension V1 est donc mesurée à un instant prédéterminé sur sa borne d'entrée et elle est appliquée sur la borne de sortie du second échantillonneur-bloqueur 4. La borne de sortie du second échantillonneur-bloqueur 4 est connectée à une première entrée d'un second comparateur 5 à sortie numérique sur un bit. La tension de référence Vref est appliquée à une seconde entrée du second comparateur 5. Le second comparateur 5 compare alors la tension de référence Vref à la première tension intermédiaire V1 et il délivre en sortie, sur une seconde sortie numérique du convertisseur, le second bit *B*_{*i*+1} de conversion. La valeur du second bit *B*_{*i*+1} est égale à 0 ou 1 selon le résultat de la comparaison ici entre la tension de référence Vref et la première tension intermédiaire V1.

Le convertisseur comporte également dans ce premier étage un moyen 6 de calcul d'une tension résiduelle V2, tel qu'un second calculateur. Cette tension résiduelle V2 qui peut être également assimilée à une seconde tension intermédiaire est fonction de tensions représentatives, avantageusement des multiples, des première Va et seconde Vb tensions, de la tension à convertir Vin et des premier *Bi* et second *B*_{*i*+1} bits. Le second calculateur 6 délivre, sur la borne de sortie analogique A du premier étage, la tension résiduelle V2 qui est égale ou représentative de la tension 4Vin -(Va+Vb)+ *Bi*.(Va-Vb)+*B̅i*.(Vb-Va) -(Va+Vb)/2 + *B*_{*i*+1}*.(Va-Vb)*/*2+B̅*_{*i*+1} (Vb-Va)/2 avec *B̅*_{*i*+1} égale à 1-*B*_{*i*+1}. La tension résiduelle V2 peut également être écrite sous la forme V2 = 4Vin - 2*B̅i*.Va - 2*Bi*.Vb *- B*_{*i*+1}*.Vb - B̅*_{*i*+1.} Va avec *B̅*_{*i*+1} égale à 1- *B*_{*i*+1} .

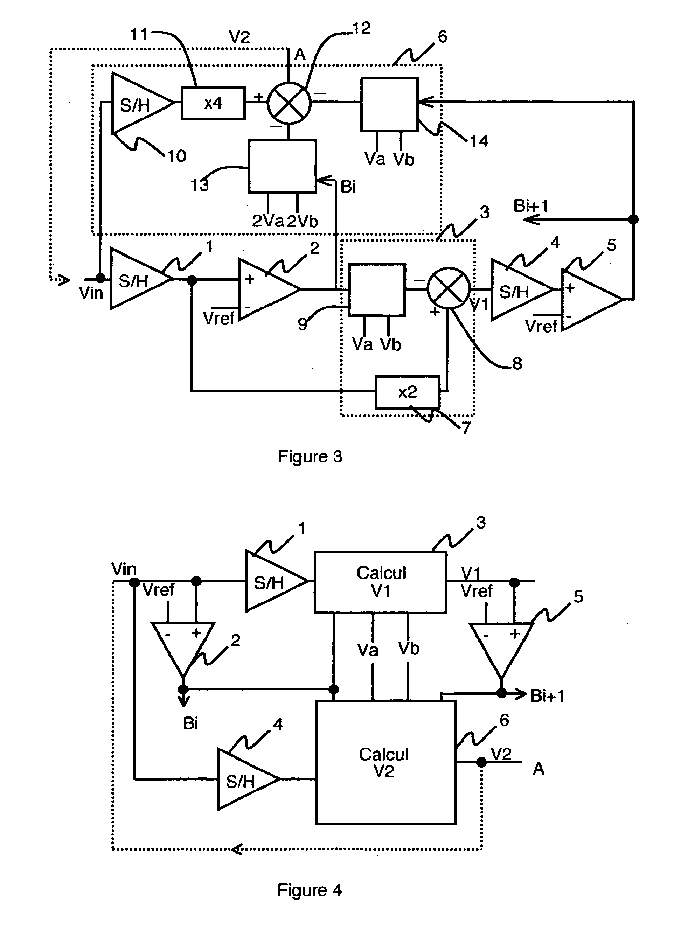

Comme illustré à la figure 3, dans un mode de réalisation particulier du mode plus général illustré à la figure 2, l'étage du convertisseur analogique-numérique comporte une borne d'entrée, sur laquelle la tension Vin est appliquée, deux bornes de sortie numérique et une borne de sortie analogique A. Ce mode de réalisation correspond à un mode de gestion des tensions dans lequel les tensions définissant les limites de la gamme de tension accessible sont fixes et la tension à convertir Vin évolue au fur et à mesure de sa conversion en une donnée numérique, via ses tensions intermédiaires successives.

La borne d'entrée du convertisseur est constituée par l'entrée du premier échantillonneur-bloqueur 1. La borne de sortie du premier échantillonneur-bloqueur 1 est connectée à une première borne d'entrée du premier comparateur 2. La deuxième borne d'entrée du premier comparateur 2 est connectée à la tension de référence Vref. La borne de sortie du premier échantillonneur-bloqueur 1 est également connectée à une borne d'entrée d'un circuit multiplicateur 7 par deux (x2) dont la borne de sortie est connectée à une première borne d'entrée d'un premier circuit sommateur 8. La seconde borne d'entrée du premier circuit sommateur 8 est connectée à une borne de sortie d'un premier convertisseur numérique-analogique 9 dont une borne d'entrée est connectée à la borne de sortie du premier comparateur 2. Le premier convertisseur 9 numérique-analogique comporte des bornes de références sur lesquelles sont appliquées respectivement des tensions représentatives des première Va et seconde Vb tensions. Selon la valeur du premier bit *Bi* appliqué au premier convertisseur 9 numérique-analogique, ce dernier délivre en sortie l'opposé de la première tension -Va ou l'opposé de la seconde tension -Vb. Ainsi, selon la valeur du premier bit *Bi,* la tension en sortie du circuit sommateur 8 est égale à la première tension intermédiaire V1, ici 2*Vin - *Bi*Vb *- B̅i*Va.

Dans le mode de réalisation encore plus particulier de la figure 3, le circuit sommateur est un circuit soustracteur. Dans ce cas de figure, la borne de sortie du convertisseur 9 numérique-analogique délivre les première ou seconde tensions Va ou Vb et elle est connectée à une borne d'entrée de type moins. La borne de sortie du circuit multiplicateur 7 est connectée sur une borne d'entrée de type plus.

La borne de sortie du premier circuit sommateur 8 est connectée à la borne d'entrée du second échantillonneur-bloqueur 4 dont la borne de sortie est connectée à la première borne d'entrée, par exemple la borne plus, du second comparateur 5 à sortie numérique. La seconde borne d'entrée, par exemple la borne moins, du second comparateur 5 est connectée à la tension de référence Vref. Comme précédemment, le second comparateur 5 délivre sur la seconde sortie numérique du convertisseur un second bit *B*_{*i*+1} représentatif de la comparaison entre la tension de référence Vref et la première tension intermédiaire V1.

La tension à convertir Vin est également appliquée à une borne d'entrée d'un troisième échantillonneur-bloqueur 10 dont la borne de sortie est connectée à la borne d'entrée d'un circuit multiplicateur 11 par quatre. Ainsi, le troisième échantillonneur-bloqueur 10 et le circuit multiplicateur 11 par quatre (x4) sont connectés en série entre la borne d'entrée du premier échantillonneur-bloqueur 1 et une première borne d'entrée du second circuit sommateur 12. La borne de sortie du circuit multiplicateur 11 par quatre est connectée à une première borne d'entrée du second circuit sommateur 12. La borne de sortie du premier comparateur 2 est connectée à une entrée d'un second convertisseur numérique-analogique 13 et la borne de sortie du second comparateur 5 est connectée à la borne de commande d'un troisième convertisseur numérique-analogique 14. Les bornes de sortie des second 13 et troisième 14 convertisseurs numérique-analogique sont connectées respectivement à des seconde et troisième bornes d'entrée du second circuit sommateur 12. La borne de sortie du second circuit sommateur 12 correspond à la borne de sortie analogique A du convertisseur. Avantageusement, les second 13 et troisième 14 convertisseurs numérique-analogique sont réalisés dans un même bloc électronique.

Cette borne de sortie analogique A peut être connectée, comme dans la figure 3, à l'entrée de l'échantillonneur-bloqueur 1 ce qui permet d'utiliser de nouveau le convertisseur pour déterminer les deux bits suivants de la tension Vin. De manière classique dans le calculateur 6, l'opération de multiplication par quatre et l'opération de soustraction sont réalisées dans un même bloc électronique.

Des tensions représentatives des première Va et seconde Vb tensions sont appliquées au second convertisseur numérique-analogique 13, ces tensions représentatives peuvent être respectivement le double des première 2Va et seconde 2Vb tensions. Le premier bit *Bi* étant appliqué au second convertisseur numérique-analogique 13, la tension analogique délivrée en sortie est fonction de la valeur de ce premier bit et de tensions représentatives des tensions Va et Vb. Les première Va et seconde Vb tensions ou des tensions représentatives de ces dernières, avantageusement des multiples, peuvent être appliquées au troisième convertisseur numérique-analogique 14. De cette manière, le second circuit sommateur 12 délivre sur la sortie analogique du convertisseur la tension résiduelle qui est fonction des première Va et seconde Vb tensions et des valeurs des premier et second bit et de la tension à convertir Vin.

Le fonctionnement du convertisseur analogique-numérique peut être expliqué de la manière suivante pour une division de la gamme de tensions en deux sous-gammes. La tension à convertir Vin est appliquée à l'entrée du premier échantillonneur-bloqueur 1 qui va mesurer la tension Vin et fournir une tension équivalente pendant une première période. Le premier comparateur 2 compare alors les tensions à ses bornes d'entrée, c'est-à-dire qu'il compare la tension Vin à la tension de référence Vref, et il délivre en sortie un premier bit *Bi* (0 ou 1) représentatif de cette comparaison. Si la tension à convertir Vin est supérieure à la tension Vref, le premier comparateur 2 renvoie un « 1 » en sortie, dans le cas contraire, il renvoie un « 0 » en sortie. Ce signal binaire est appliqué à l'entrée du premier convertisseur numérique-analogique 9 qui applique alors sur sa borne de sortie, l'inverse de la première Va ou de la seconde Vb tension.

Durant cette première période, la borne de sortie du premier convertisseur numérique-analogique 9 et la borne de sortie du circuit multiplicateur 7 par deux étant connectées toutes deux aux bornes d'entrée du circuit sommateur 8, le circuit sommateur 8 délivre en sortie la différence entre deux fois la tension Vin et la valeur absolue de la première ou de la seconde tension (2*Vin - *Bi*Vb *- B̅i*Va). De ce fait, pendant la première période, la tension à convertir Vin est échantillonnée puis comparée pour obtenir le premier bit et la première tension intermédiaire V1 est calculée et appliquée à l'entrée du second échantillonneur bloqueur.

Cette tension est ensuite échantillonnée et bloquée par le second échantillonneur bloqueur 4 pour que dans une deuxième période, la tension fournie par le premier circuit sommateur 8 soit convertie en un second bit *B*_{*i*+1} par le second comparateur 5. Lors de cette deuxième période, une tension analogique représentative des deux bits (*Bi* et *B*_{*i*+1}), est soustraite à quatre fois la tension à convertir (4Vin) et cette différence correspond à la tension résiduelle V2, c'est-à-dire au résidu de type analogique qui est appliqué sur la sortie A à un autre convertisseur (ou une autre itération) pour la détermination d'autres bits si cela est nécessaire.

Ainsi, lors de la première période, le bit *Bi* le plus significatif est déterminé par le premier comparateur 2 pour la tension Vin et lors de la période suivante, le bit suivant *B*_{*i*+1} est déterminé au moyen du second comparateur 5. Ce mode de fonctionnement est spécifique aux convertisseurs illustrés aux figures 2 et 3, mais il est facilement transposable aux autres modes de réalisation ci-dessous.

Dans une variante de réalisation, illustrée à la figure 4, le convertisseur est associé à un circuit qui lui délivre une tension à convertir Vin qui est déjà échantillonnée au niveau du circuit.

La tension à convertir Vin est appliquée à une entrée d'un premier échantillonneur-bloqueur 1 qui est lui-même connecté à un premier calculateur 3 de la première tension intermédiaire V1, par l'intermédiaire de sa borne de sortie. La tension à convertir Vin est également connectée à une entrée d'un second échantillonneur-bloqueur 4 qui est lui-même connecté à un second calculateur 6 de la seconde tension intermédiaire V2, par l'intermédiaire de sa borne de sortie. La tension à convertir Vin est également appliquée à une première entrée, ici l'entrée plus, d'un premier comparateur 2 dont une tension de référence Vref est appliquée à une seconde entrée, ici l'entrée moins. Une borne de sortie du premier comparateur 2 est connectée à une borne d'entrée digitale des calculateurs 3 et 6. De cette manière, la tension à convertir Vin est comparée à la tension de référence Vref au moyen du premier comparateur 2 et le résultat de cette comparaison, un bit *Bi,* est appliquée aux calculateurs 3 et 6.

Les calculateurs 3 et 6 comportent également des bornes d'entrée sur lesquelles sont appliquées la première tension Va et la seconde tension Vb ou des tensions représentatives de ces dernières, typiquement des multiples de ces dernières. Le calculateur 3 de la première tension intermédiaire V1 délivre sur une borne de sortie la tension intermédiaire V1. Cette tension intermédiaire V1 est appliquée sur une première borne d'entrée, ici la borne plus, d'un second comparateur 5 dont une tension de référence Vref est appliquée à une seconde entrée, ici l'entrée moins. De cette manière, la tension intermédiaire V1 est comparée à la tension de référence Vref au moyen du second comparateur 5 et le résultat de cette comparaison, un autre bit *B*_{*i*+1}, est appliqué au calculateur 6 de la tension résiduelle V2. Selon l'architecture d'intégration dans laquelle le convertisseur est utilisé, la tension V2 peut être appliquée à l'étage suivant ou alors appliquée de nouveau à l'entrée du convertisseur, c'est-à-dire sur les premier et second échantillonneurs-bloqueurs 1 et 4 et sur le premier comparateur 2. Cette architecture est plus avantageuse car la tension V2 est obtenue en une étape au lieu de deux étapes selon l'art antérieur. Ce mode de réalisation est également plus rapide car la comparaison peut être réalisée pendant l'étape d'échantillonnage-blocage, ce qui n'est pas le cas dans l'art antérieur. L'utilisation d'une multiplication par quatre de la tension à convertir Vin dans le convertisseur permet d'obtenir une résolution plus importante et un résidu plus précis, utilisé dans l'itération ou l'étage suivant.

Dans un mode de réalisation avantageux de ce convertisseur analogique-numérique sur deux bits, la conversion est réalisée à chaque itération et se décompose en une pluralité de phases élémentaires qui peuvent comporter chacune un ou plusieurs cycles d'horloge. En effet, à titre d'exemple, selon la quantité de dispositifs échantilloneur-bloqueur intégrés dans le convertisseur et leur disposition dans le circuit, le nombre de coup d'horloge va évoluer pour obtenir un résultat similaire à 4Vin -(Va+Vb)+*Bi.*(Va-Vb)+*B̅i.*(Vb-Va)-(Va+Vb)/2 +*B*_{*i*+1}.(Va-Vb)/2+*B̅*_{*i*+1} (Vb-Va)/2.

A titre d'exemple, un fonctionnement possible du mode de réalisation illustré à la figure 4 est explicité pour une itération. Dans une première phase, la tension à convertir Vin est appliquée à l'entrée du convertisseur. Dans cette première période, à un instant t1, le premier échantillonneur/bloqueur 1 est commandé pour réaliser l'échantillonnage et le blocage de la tension à convertir Vin qui est appliquée à son entrée. Le premier échantillonneur/bloqueur 1 délivre alors, sur une borne de sortie, une tension représentative de la tension Vin, de préférence une tension égale à la tension à convertir.

Durant la première période, à l'instant t1 ou à un autre instant, la tension à convertir Vin est comparée à la tension de référence Vref, suivant que la tension à convertir Vin est supérieure ou inférieure à la tension de référence Vref, le premier comparateur 2 délivre un premier bit *Bi* égale respectivement à 1 ou 0. Avantageusement, la comparaison à la tension de référence est réalisée en fin de période, juste avant t1, quand le signal est bien établi en entrée de l'échantillonneur-bloqueur.

Dans une seconde période, le calculateur 3 réalise le calcul de la première tension intermédiaire V1. Le calcul est réalisé en fonction de deux paramètres déterminés durant la première période, le premier bit *Bi* et la tension échantillonnée représentative de la tension Vin.

Dans une troisième période, la première tension intermédiaire V1 est comparée à la tension de référence Vref. Suivant que la première tension intermédiaire V1 est supérieure ou inférieure à la tension de référence Vref, le second comparateur 5 délivre un second bit *B*_{*i*+1} égal respectivement à 1 ou 0.

La tension à convertir Vin est également échantillonnée et bloquée par le second échantillonneur/bloqueur 4 de manière à délivrer une tension constante sur le calculateur 6 de la tension résiduelle V2. Cet échantillonnage et ce blocage peuvent être réalisés indépendamment pendant les première, seconde et troisième périodes. Cependant, de manière avantageuse, l'échantillonnage et le blocage par le second échantillonneur/bloqueur sont réalisés pendant la première période en même temps que l'échantillonnage par le premier échantillonneur bloqueur 1. De cette manière, la même tension représentative de la tension à convertir Vin est appliquée aux calculateurs 3 et 6.

Dans une quatrième période, le calculateur 6 calcule la tension résiduelle V2, en fonction du premier bit *Bi*, déterminé durant la première période, du second bit *B*_{*i*+1} déterminé durant la troisième période et de la tension appliquée par le second échantillonneur/bloqueur 4. La première tension intermédiaire V1 n'est pas utilisée par le calculateur 6 afin de ne pas introduire les erreurs liées au calculateur 3 dans le calcul de la tension résiduelle V2.

De manière générale, le convertisseur réalise dans un premier temps, l'extraction du premier bit *Bi* puis dans un deuxième temps, l'extraction du deuxième bit *B*_{*i*+1} au moyen de la tension Vin, des première Va et seconde Vb tensions et du premier bit. De cette façon, le convertisseur ne permet pas une augmentation de la vitesse de conversion, mais autorise une augmentation de la précision de la conversion et une réduction de la consommation énergétique.

Dans un mode de réalisation privilégié, illustré à la figure 5, les moyens de comparaisons 2 et 5 comportent une architecture de type RSD (« Redundant signed digit » en anglais) qui permet un fonctionnement plus robuste du convertisseur. Au moyen de cette architecture particulière, les imprécisions liées aux comparateurs présents dans les moyens de comparaison 2 et 5 sont réduites. La gamme accessible à la tension à convertir Vin et aux tensions intermédiaire est divisée en un nombre impair de sous-gammes, par exemple trois sous-gammes. Pour un découpage en trois sous-gammes, les moyens de comparaison 2 et 5 comportent chacun deux comparateurs élémentaires 2a, 2b et 5a, 5b. Les moyens de comparaison délivrent alors un résultat numérique sur deux bits. Cependant, ces deux bits ne pouvant pas prendre toutes les valeurs possibles, il est nécessaire de retravailler ce signal numérique pour en faire un véritable signal binaire. Les premiers comparateurs élémentaires 2a et 5a des moyens de comparaison 2 et 5 ont une première borne d'entrée connectée à une première tension de référence Vref⁻ et ont une seconde borne d'entrée connectée respectivement à la tension à convertir Vin et à la première tension intermédiaire. De cette manière, les premiers comparateurs élémentaires 2a et 5a réalisent la comparaison de la tension à convertir ou de la première tension intermédiaire V1 à la première tension de référence. Une connexion et un fonctionnement similaires sont réalisés pour les seconds comparateurs élémentaires 2b et 5b des moyens de comparaison 2 et 5. Les seconds comparateurs élémentaires 2b et 5b réalisent la comparaison de la tension à convertir Vin ou de la première tension intermédiaire V1 avec la seconde tension de référence Vref⁺.

Dans ce mode de réalisation particulier, la gamme accessible à la tension à convertir Vin est divisée en trois sous-gammes au moyen des première et seconde tensions de référence Vref⁻ et Vref⁺. Les première et seconde tensions de références sont des tensions qui se situent dans la gamme définie par les première Va et seconde Vb tensions. La gamme de tension accessible étant divisée en trois sous-gammes égales ou non, les moyens de comparaison 2 et 5 délivrent chacun en sortie deux bits élémentaires *Bi*⁻, *Bi*⁺ et *B*_{*i*+1}⁻ *B*_{*i*+1}⁺. Les valeurs des différents bits représentent le positionnement de la tension à convertir Vin ou de la première tension intermédiaire V1 dans la gamme accessible. De ce fait, toutes les combinaisons entre les bits *Bi⁻* et *Bi⁺* ou entre les bits *B*_{*i*+1}*⁻* et *B*_{*i*+1}*,⁺* ne sont pas possibles. Dans ce mode de réalisation particulier, le convertisseur comporte des moyens de transcription des bits élémentaires obtenus sur les différentes itérations en un format binaire représentatif de la tension à convertir Vin. La réalisation d'un convertisseur suivant une architecture de type RSD est décrit par exemple par Ginetti et al dans la publication citée précédemment.

Dans cette architecture particulière, les calculateurs 3 et 6 prennent en compte la présence des deux bits élémentaires délivrés par les moyens de comparaisons 2 et 5. En définissant, (Va+Vb)/2 ≤ Vref⁺ < (Va+Vb)/2 + (Vb-Va)/4 et (Va+Vb)/2 + (Va-Vb)/4 < Vref⁻ ≤ (Va+Vb)/2, la tension délivrée par le premier moyen de calcul 3 peut être définie comme étant égale à 2Vin - *(Bi⁻* ET *Bi*⁺).Vb - *(Bi⁻* OUEX *Bi*⁺).(Va+Vb)/2 - (*B̅i̅⁻̅* ET *̅B̅i̅*̅⁺̅).Va, la tension résiduelle V2 délivrée par le second moyen de calcul 6 peut, pour sa part être définie comme étant égale à 4Vin - *2(B̅i̅⁻̅* ET *Bi⁺).Vb - 2(Bi⁻* OUEX Bi⁺).(Va+Vb)/2 - *2(B̅i̅⁻̅* ET *B̅i̅⁺̅).Va - (B*_{*i*+1}*⁻* ET *B*_{*i*+1}⁺). Vb *- (Bᵢ₊₁⁻* OUEX *B*_{*i*+1}⁺).(Va+Vb)/2 - (*̅B̅*̅_̅{̅*̅i̅*̅+̅1̅}̅*̅⁻̅*̅ ET *̅B̅*̅_̅{̅*̅i̅*̅+̅1̅}̅⁺̅).Va. ET et OUEX (ou exclusif) représentent les opérateur booléen. Ces équations peuvent également être écrites sous la même forme que précédemment.

Cette architecture particulière permet également d'augmenter la précision du convertisseur pour une même résolution numérique, c'est-à-dire pour une conversion sur un même nombre de bits. Au moyen d'un tel convertisseur qui intègre un moyen de calcul sur deux signaux binaires, les dégradations du signal analogique en sortie A du convertisseur sont réduites par rapport à l'utilisation de deux étages successifs ayant chacun leurs propres moyens de calcul de tensions intermédiaires. De plus, cette séparation du codage numérique et du calcul d'un résidu analogique permet d'optimiser les propriétés de ces deux branches et de délivrer en sortie du convertisseur un résidu, c'est-à-dire une seconde tension intermédiaire, avec une meilleure précision. Cette seconde tension intermédiaire étant utilisée pour l'obtention des deux bits successifs, il en résulte alors une augmentation de la précision du code binaire provenant de la conversion de la tension Vin. Cette architecture permet également une réduction de la consommation et de l'encombrement par rapport aux autres convertisseurs analogique-numérique sur deux bits (c'est-à-dire deux convertisseurs sur un bit mis en série), ce qui en fait une architecture particulièrement avantageuse.

De manière classique, les fonctions d'échantillonnage et de calcul des échantillonneurs-bloqueurs et des moyens de calcul peuvent être réalisées au sein d'un même élément qui est généralement réalisé à l'aide d'un montage de capacités commutées.

Dans un mode de réalisation non représenté, il est envisageable de réaliser la mutualisation des moyens de comparaison. Cette mutualisation peut être réalisée, par exemple, par des interrupteurs.

Dans un mode de réalisation avantageux, quand le convertisseur est dans une architecture dite « pipeline », les deux étages successifs sont en opposition de phase. Dans ces conditions, l'un des étages réalise l'échantillonnage pendant que l'autre étage réalise l'opération de multiplication et inversement.

Dans une variante de réalisation non représentée, la tension de référence peut être appliquée sur la borne plus des comparateurs 2 et 5 et la tension à comparer sur la borne moins. Le résultat obtenu étant opposé, il est nécessaire de modifier le mode de traitement de l'information, mais le fonctionnement général du convertisseur est inchangé.

De manière générale, le premier étage du convertisseur peut être décomposé en deux sous-étages d'approximation qui délivrent chacun un résultat numérique. Le premier sous-étage d'approximation est connecté à la borne d'entrée du convertisseur et il délivre une première valeur numérique qui représente au moins le bit de poids fort (MSB). Le premier étage délivre également une tension analogue à partir de la tension à convertir Vin, de la valeur du résultat numérique et des première et seconde tensions.

Le second étage d'approximation est connecté à la borne d'entrée du convertisseur de manière à recevoir la tension à convertir Vin. Il délivre un second résultat numérique qui suit le résultat numérique délivré par le premier étage d'approximation dans le résultat numérique final et qui provient de la première tension intermédiaire. Il délivre encore la tension résiduelle V2 à partir de la tension à convertir Vin, des premier et second résultats numériques et des première et seconde tensions Va et Vb.

De manière encore plus générale, le convertisseur à approximations successives peut délivrer plus de deux bits avec plus d'étages. Il comporte alors une succession d'étages d'approximation avec autant d'étages que de bits délivrés. Dans le cas où le convertisseur comporte une pluralité d'étages, chaque étage comporte une entrée et une sortie analogique, un calculateur et au moins un comparateur selon le type de découpage de la gamme de conversion. Chaque étage délivre un résultat numérique sur une sortie numérique, par exemple un bit et une tension analogique sur la sortie analogique. Cette tension analogique qui sert à déterminer le résultat numérique de l'étage suivant ou la tension résiduelle du convertisseur.

Chaque calculateur est connecté à la borne d'entrée du convertisseur pour recevoir la tension d'entrée Vin, à son comparateur associé pour recevoir le résultat numérique de son étage et aux comparateurs des étages précédents délivrant des bits de poids plus forts afin de calculer et délivrer la tension analogique de cet étage. Chaque comparateur est connecté à la borne de sortie de l'étage précédent afin de délivrer un résultat numérique représentatif de la tension analogique de l'étage précédent. Comme tous les calculateurs sont reliés à la borne d'entrée de l'étage du convertisseur, il n'y a pas de distorsion du signal d'entrée au fur et à mesure des conversions. Un étage reçoit donc un signal analogique provenant de l'étage précédent pour déterminer une valeur numérique et il délivre une tension analogique à l'étage suivant et une valeur numérique à tous les autres étages suivants. La sortie analogique A du convertisseur est connectée à une entrée du second calculateur, c'est-à-dire le calculateur du second étage.

## Revendications

1. Convertisseur analogique-numérique à approximations successives comportant :
- une borne d'entrée d'un étage sur laquelle est appliquée une tension à convertir (Vin), la tension à convertir étant comprise dans un gamme de conversion délimitée par des première (Va) et seconde (Vb) tensions,
- un premier comparateur (2) de la tension à convertir (Vin) à au moins une première tension de référence (Vref), ledit premier comparateur (2) délivrant, sur une première sortie numérique, une première valeur numérique sur au moins un premier bit (Bi) représentatif de ladite comparaison,
- un premier calculateur (3) délivrant une première tension intermédiaire (V1) fonction de la tension à convertir (Vin), de la première valeur numérique et desdites première (Va) et seconde (Vb) tensions, le premier calculateur (3) étant relié à la borne d'entrée,
- un second comparateur (5) de la première tension intermédiaire (V1) à au moins une seconde tension de référence (Vref), ledit second comparateur (5) délivrant, sur une seconde sortie numérique, une seconde valeur numérique sur au moins un second bit (*B*ᵢ₊₁) représentatif de ladite comparaison,
- un second calculateur (6) d'une tension résiduelle (V2) délivrant sur une sortie analogique (A) du convertisseur ladite tension résiduelle (V2) à partir de la tension à convertir (Vin), des premières et secondes valeurs numériques et desdites première (Va) et seconde (Vb) tensions, le second calculateur étant relié à la borne d'entrée pour recevoir la tension à convertir (Vin),
la tension résiduelle (V2) étant appliquée à l'entrée du convertisseur ou à une entrée d'un étage ultérieur de même type.

2. Convertisseur selon la revendication 1 **caractérisé en ce que** la tension résiduelle (V2) est représentative de 4Vin - (Va+Vb) + *Bi*.(Va-Vb) +*B̅i*.(Vb-Va) - (Va+Vb)/2 + *B*_{*i*+1}.(Va-Vb)/2 + *B̅*_{*i*+1}.(Vb-Va)/2.

3. Convertisseur selon la revendication 1, **caractérisé en ce que** le premier comparateur (2) est constitué par deux comparateurs numériques (2a, 2b) sur un bit.

4. Convertisseur selon l'une des revendications 1 et 3, **caractérisé en ce que** le second comparateur (5) est constitué par deux comparateurs numériques (2a, 2b) sur un bit.

5. Convertisseur selon les revendications 3 et 4, **caractérisé en ce que** la tension résiduelle (V2) est représentative de 4Vin - 2(*Bi*⁻ ET *Bi*⁺).Vref⁺ - 2(*Bi*⁻ OU *Bi*⁺).(Va+Vb)/2 - 2(*̅B̅i̅*̅⁻̅ ET *̅B̅i̅*̅⁺̅).Vref⁻ - (*B*_{*i*+1}⁻ ET *B*_{*i*+1}⁺). Vref⁺ *-* (*B*ᵢ₊₁⁻ OU *B*_{*i*+1}⁺).(Va+Vb)/2 - (*̅B̅*̅ᵢ̅₊̅₁̅⁻̅ ET *̅B̅*̅ᵢ̅₊̅₁̅⁺̅).Vref⁻.

## Patentansprüche

1. Analog-Digital-Wandler mit schrittweiser Annäherung, umfassend:
- einen Eingangsanschluss einer Stufe, an den eine zu wandelnde Spannung (Vin) angelegt ist, wobei die zu wandelnde Spannung in einem durch eine erste Spannung (Va) und eine zweite Spannung (Vb) begrenzten Umsetzungsbereich liegt,
- einen ersten Komparator (2) für die zu wandelnde Spannung (Vin) mit wenigstens einer ersten Referenzspannung (Vref), wobei der erste Komparator (2) an einem ersten Digitalausgang einen ersten Zahlenwert mit wenigstens einem ersten Bit (Bi), das für den Vergleich repräsentativ ist, liefert,
- einen ersten Rechner (3), der eine erste Zwischenspannung (V1) liefert, die von der zu wandelnden Spannung (Vin), von dem ersten Zahlenwert sowie von der ersten Spannung (Va) und der zweiten Spannung (Vb) abhängig ist, wobei der erste Rechner (3) mit dem Eingangsanschluss verbunden ist,
- einen zweiten Komparator (5) für die erste Zwischenspannung (V 1) mit wenigstens einer zweiten Referenzspannung (Vref), wobei der zweite Komparator (5) an einem zweiten Digitalausgang einen zweiten Zahlenwert mit wenigstens einem zweiten Bit (Bᵢ₊₁), das für den Vergleich repräsentativ ist, liefert,
- einen zweiten Rechner (6) für eine Restspannung (V2), der an einem Analogausgang (A) des Wandlers die Restspannung (V2) anhand der zu wandelnden Spannung (Vin), des ersten und des zweiten Zahlenwertes sowie der ersten Spannung (Va) und der zweiten Spannung (Vb) liefert, wobei der zweite Rechner mit dem Eingangsanschluss verbunden ist, um die zu wandelnde Spannung (Vin) aufzunehmen,
wobei die Restspannung (V2) an den Eingang des Wandlers oder an einen Eingang einer späteren Stufe gleichen Typs angelegt wird.

2. Wandler nach Anspruch 1, **dadurch gekennzeichnet, dass** die Restspannung (V2) für 4*Vin -* (*Va* + *Vb*) + *Bi.*(*Va - Vb*) + *B̅i.(Vb - Va) - (Va* + *Vb*)/2 + *B*ᵢ₊₁.(*Va* - *Vb*)/2 + *B̅*_{*i*+1}(*Vb* - *Va*)/2 repräsentativ ist.

3. Wandler nach Anspruch 1, **dadurch gekennzeichnet, dass** der erste Komparator (2) durch zwei digitale Ein-Bit-Komparatoren (2a, 2b) gebildet ist.

4. Wandler nach einem der Ansprüche 1 und 3, **dadurch gekennzeichnet, dass** der zweite Komparator (5) durch zwei digitale Ein-Bit-Komparatoren (2a, 2b) gebildet ist.

5. Wandler nach den Ansprüchen 3 und 4, **dadurch gekennzeichnet, dass** die Restspannung (V2) für *4Vin -* 2(*Bi⁻ UND Bi*⁺)*.Vref*⁺ *-* 2(*Bi*⁻ *ODER Bi⁺*)*.*(*Va +Va*)/2 *-* 2(*B̅i̅⁻̅ UND* *̅B̅i̅*̅⁺̅)*.Vref*⁻ *-* (*Bᵢ₊ᵢ⁻ UND B*_{*i*+1}⁺)*.Vref*⁺ *- (B*ᵢ₊₁*⁻ODER B*_{*i+*1}*⁺* ).(*Va + Vb*) / 2 - *(**̅B̅*̅_̅{̅*̅i̅+̅*̅1̅}̅*⁻̅ UND* *̅B̅*̅ᵢ̅₊̅₁̅⁺̅).*Vref*⁻ repräsentativ ist.

## Claims

1. A successive-approximation analog-to-digital converter comprising:
- an input terminal of a stage on which is applied a voltage to be converted (Vin), the voltage to be converted being comprised in a conversion range delimited by first (Va) and second (Vb) voltages,
- a first comparator (2) of the voltage to be converted (Vin) to at least a first reference voltage (Vref), said first comparator (2) providing a first digital value on at least a first bit (Bi) representative of said comparison on a first digital output,
- a first calculator (3) providing a first intermediate voltage (V1) function of the voltage to be converted (Vin), the first digital value and said first (Va) and second (Vb) voltages, the first calculator (3) being connected to the input terminal,
- a second comparator (5) of the first intermediate voltage (V1) to at least a second reference voltage (Vref), said second comparator (5) providing a second digital value on at least a second bit (*B*_{*i+*1}) representative of said comparison on a second digital output,
- a second calculator (6) of a residual voltage (V2) providing said residual voltage (V2) from the voltage to be converted (Vin), the first and second digital values and said first (Va) and second (Vb) voltages on an analog output of the converter, the second calculator being connected to the input terminal to receive the voltage to be converted (Vin),
the residual voltage (V2) being applied to the input of the converter or to an input of an next stage of the same type.

2. Converter according to claim 1, **characterized in that** the residual voltage (V2) is representative of 4Vin - (Va+Vb) + *Bi*.(Va-Vb) +*B̅i*.(Vb-Va) - (Va+Vb)/2+ *B*ᵢ₊₁.(Va-Vb)/2 + *̅B̅*̅ᵢ̅₊̅₁̅.(Vb-Va)/2.

3. Converter according to claim 1, **characterized in that** the first comparator (2) is constituted by two digital comparators (2a, 2b) on one bit.

4. Converter according to one of the claims 1 and 3, **characterized in that** the second comparator (5) is consituted by two digital comparators (2a, 2b) on one bit

5. Converter according to the claims 3 and 4, **characterized in that** the residual voltage (V2) is representative of 4Vin - 2(*Bi*⁻ AND *Bi*⁺).Vref+ - 2( *Bi⁻* OR *Bi*⁺).(Va+Vb)/2 - 2(*̅B̅i̅*̅⁻̅ AND *B̅i̅⁺̅).Vref- -* (*B*ᵢ₊₁⁻ AND *B*ᵢ₊₁⁺). Vref+ - ( *B*_{*i*+1}⁻ OR *B*ᵢ₊₁⁺).(Va+Vb)/2 - (*̅B̅*̅_̅{̅*̅i̅*̅+̅1̅}̅⁻̅ AND *̅B̅*̅ᵢ̅₊̅₁̅⁺̅).Vref-.
